# EUROPEAN PATENT SPECIFICATION

(11) **EP 3 206 262 B1**
(45) Date of publication and mention of the grant of the patent: **23.10.2019**
(21) Application number: 17150911.0
(22) Date of filing: 10.01.2017
(51) Int. Cl.: H01R 12/70, H01R 12/71, H01R 13/11, H01R 43/02, H01R 4/02, H01R 105/00, H01R 13/432, H01R 12/58, H01R 12/52

(54) **ELECTRONIC CONTROL CONNECTOR, ELECTRONIC CONTROL FOR DRIVING A HERMETIC COMPRESSOR**
VERBINDER EINER ELEKTRONISCHEN STEUERUNG, ELEKTRONISCHE STEUERUNG ZUR ANSTEUERUNG EINES HERMETISCHEN VERDICHTERS
CONNECTEUR DE COMMANDE ÉLECTRONIQUE, COMMANDE ÉLECTRONIQUE D'UN COMPRESSEUR HERMÉTIQUE

(30) Priority: 15.01.2016 CN 201620154651 U; 14.06.2016 BR 102016013673
(43) Date of publication of application: 16.08.2017
(73) Proprietor: Embraco Indústria de Compressores e Soluções em Refrigeração Ltda., 89219-100 Joinville, SC (BR)
(72) Inventor: ZANELATO, Marcelo, 89217-435 Joinville - SC (BR)
(74) Representative: Abel & Imray

(56) References cited:
- US-A- 5 772 453

## Description

The present invention relates to an electronic control connector fixed to the printed circuit board of an electronic control, the connector simultaneously being fixed to said board and establishing an electrical connection with the tracks of the printed circuit board. The connector being electrically connected to the connector of the hermetic compressor, such that the electronic control electrically drives the hermetic compressor.

### DESCRIPTION OF THE STATE OF THE ART

With the objective of achieving high energy and cooling efficiency, today household and commercial cooling systems use Variable Capacity Compressors - VCC. The characteristics of these compressors are adjustments in the cooling capacity by varying the pumping speed of cooling gas, that is, their mass flow, in accordance with the system requirement and cooling demand.

The variation in the mass flow is from a minimum value to a maximum value, said range of values being proportional to the rotation of the electric motor that drives the hermetic variable capacity compressor. The variation of the rotation is obtained in these compressors by means of an electronic control, called frequency inverter, which adjusts the voltage and the frequency applied to the electric motor.

In general terms, the frequency inverter is provided with various electronic circuits having different functions, such as, for example, a power circuit with input stage for electromagnetic interference filtering and a rectifier bridge stage tor converting an alternating current coming from an external power source into a continuous voltage, a control circuit (microcontroller or Digital Signal Processor - DSP), an auxiliary power source for generating internal voltage for other circuits or components of the inverter, a circuit formed by power semiconductors for driving the electric motor employed in the compressor, among others.

It is noted that the electrical connection and fixing of the frequency inverter to the hermetic compressor requires carrying out various steps on the production line. This results in a loss of efficiency and high production and assembly cost of the frequency inverter.

Another problem noted concerns the use of cables for electrical connection between the frequency inverter and the connector, which is generally provided with three pins, of the hermetic compressor. The use of a cable requires the fixing thereof to the printed circuit board of the frequency inverter, which results in increased general costs of production and time, due to the need to solder the cable to the board of the inverter or to use an additional connector on the board.

Additionally, it is noted in the state of the art that the frequency inverter is disposed in a closed plastic box, which is encased mechanically to the support surface ("*fence*") of the hermetic compressor, being fastened by means of screws, to meet the standard requirements.

The problems above are noted when carrying out the steps of fixing of the frequency inverter to the support surface ("*fence*") of the hermetic compressor, which will be detailed ahead.

The first step is carried out by fixing the components and circuits which make up the frequency inverter on the printed circuit board.

After this step, the connector for feeding the hermetic compressor motor is mounted on the printed circuit board. The grounding connector of the electromagnetic interference filtering circuit (ground connection point) is mounted on the printed circuit board.

The ground branch terminal is pressed in the plastic body of the outer casing.

The printed circuit board is then mounted on the plastic base of the plastic body of the outer casing.

A connection cable of the motor is connected to the connector for feeding the hermetic compressor motor, previously mounted on the printed circuit board. A grounding cable of the electromagnetic interference filtering circuit is connected to the connector positioned on the printed circuit board.

The cable coming from the grounding connector of the electromagnetic interference filtering circuit is connected to the grounding terminal fixed to the plastic body.

The plastic body of the outer casing is mounted on the plastic base, such that the cables previously mounted pass through orifices existing in said body.

The plastic lid is then closed, making interface with the base and the plastic bodies, the lid is screwed to the assembly of base and body, the connector of the cable of the motor is coupled to the connector of the hermetic compressor, a branch of the grounding cable of the electromagnetic interference filtering circuit is coupled to the ground terminal of the compressor, the plastic assembly is encased in the compressor through the orifice existing in the plastic body and the assembly is fixed to the hermetic compressor by means of screws.

US 5772453 A (Tan, Haw-Chan et al) published 30 June 1998 discloses an arrangement that includes a side-by-side dual-port USB connector assembly, formed by two standard four-pin USB connector units and a motherboard, the electrical and mechanical layout of the motherboard arranged for mounting both a traditional D-Sub connector and a USB connector.

Therefore, it is not noted in the state of the art an electronic control connector (frequency inverter) encased in the printed circuit board of an electronic control, the connector being capable of simultaneously being fixed mechanically to said board and establishing an electrical connection with the tracks of the printed circuit board. The connector being electrically connected to the connector of the hermetic compressor, such that the electronic control electrically drives the hermetic compressor. The connector enabling the elimination of cables for connection to the hermetic compressor and fewer steps for connecting the frequency inverter to the support surface of the hermetic compressor.

### OBJECTIVES OF THE INVENTION

The first objective of the present invention is to provide connection means of an electronic control, which require a fewer number of steps necessary for assembling and subsequent connection to the hermetic compressor.

The second objective of the present invention is to provide connection means of an electronic control, which eliminate the need to use cables for connection to the hermetic compressor.

A third objective of the present invention is to provide connection means of an electronic control, which have lower manufacturing costs.

A fourth objective of the present invention is to provide connection means of an electronic control having lower costs in the operation of assembling the compressor.

A fifth objective of the present invention is to provide a fast connection and disconnection of the electronic control connector.

### BRIEF DESCRIPTION OF THE INVENTION

In accordance with aspects of the invention there is provided an electronic control connector to connect a pin of a connector of a hermetic compressor to a track of a printed circuit board, and an electronic control for driving a variable capacity hermetic compressor, as defined in the appended claims.

### SUMMARIZED DESCRIPTION OF THE DRAWINGS

The present invention will now be described in greater detail based on a sample execution represented in the drawings. The drawings show:
Figure 1 is an illustration of the electronic control seen from the first face of the printed circuit board, showing at least a fixing orifice for encasing the connector, according to the teachings of the present invention;
Figure 2 is a top view of the electronic control connector, according to the teachings of the present invention;
Figure 3 is a bottom view of the electronic control connector, according to the teachings of the present invention;
Figures 4 to 9 are illustrations of the terminals which are inserted inside the input orifices of the electronic control connector, according to the teachings of the present invention;
Figure 10 is a bottom view of the electronic control connector, showing the terminals inserted into the orifices of the connector, according to the teachings of the present invention;
Figure 11 is a top view of the electronic control connector with the terminals inserted into its orifices, according to the teachings of the present invention;
Figure 12 is an illustration of the electronic control connector encased in the second face of the printed circuit board, according to the teachings of the present invention;
Figure 13 is an illustration of the hermetic compressor, showing its connector and its support surface, according to the teachings of the present invention;
Figure 14 is an illustration of the electronic control to be connected to the hermetic compressor, by means of the electrical connection between its respective connectors, according to the teachings of the present invention;
Figure 15 is an illustration of the electronic control connected to the hermetic compressor, according to the teachings of the present invention;
Figure 16 is a sectional view of the connection of the electronic control of the hermetic compressor, showing the mechanical fixing of the electronic control connector to the printed circuit board and the electrical connection between a terminal of the electronic control connector and a pin of the connector of the hermetic compressor. The picture also illustrates the terminal of the electronic control connector in contact with the printed circuit board; and
Figure 17 is an illustration of the electronic control to be connected to the connector of the hermetic compressor and to the support surface of the hermetic compressor, according to the teachings of the present invention.

### DETAILED DESCRIPTION OF THE DRAWINGS

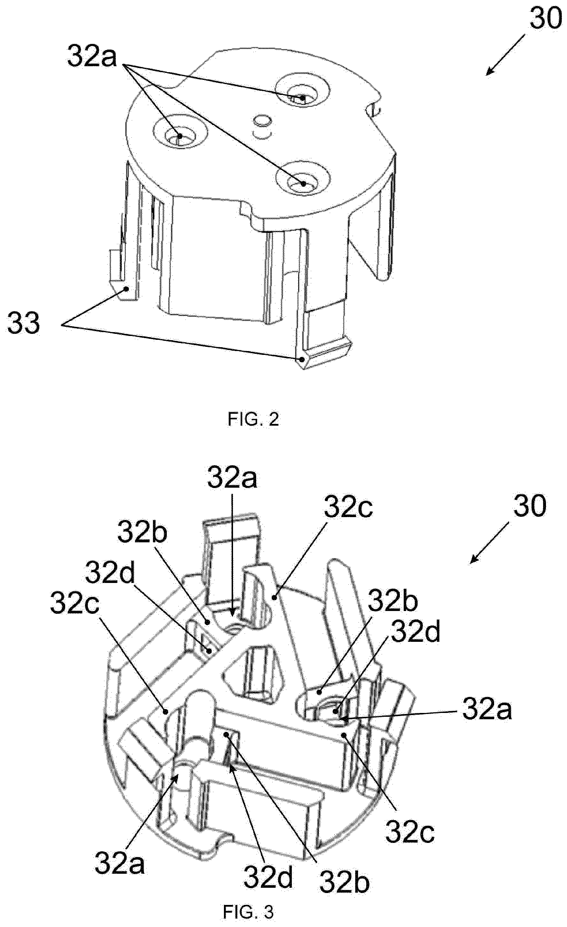

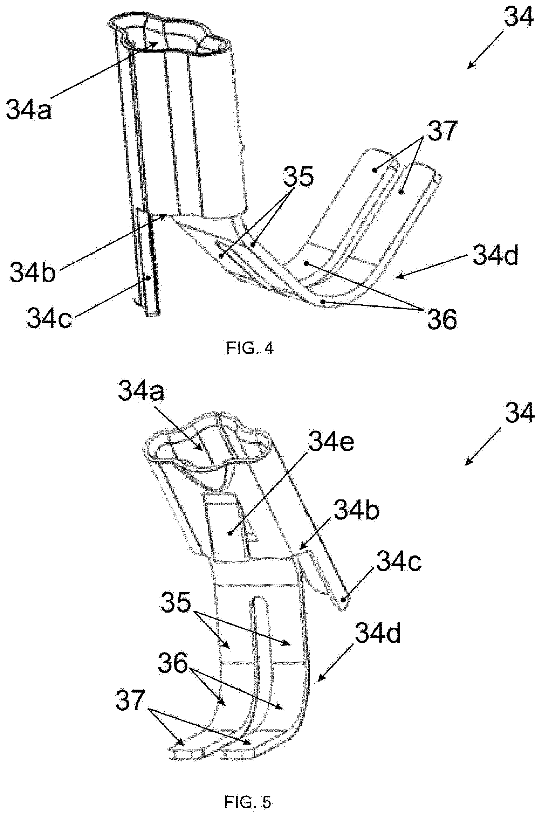

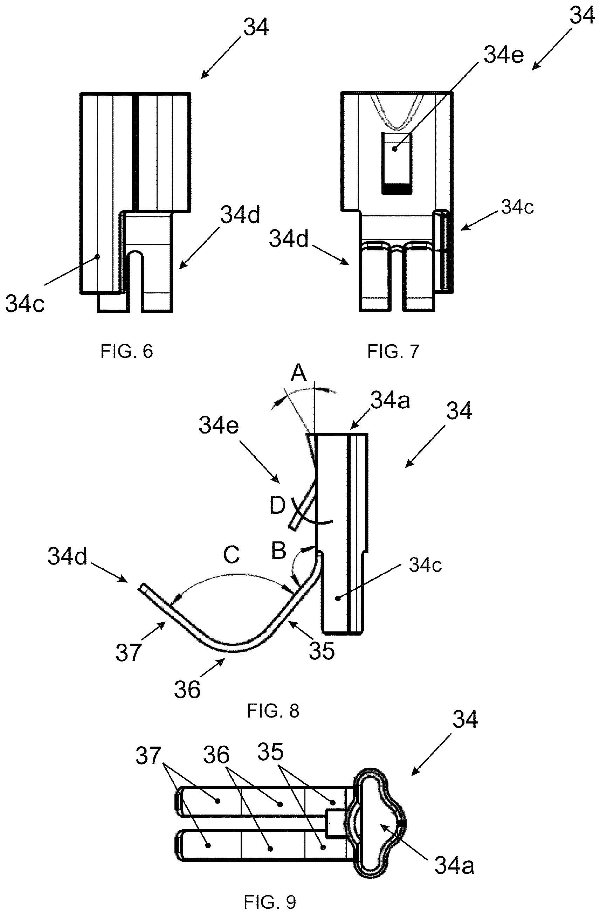

Figures 2 to 3 illustrate the electronic control connector 30 and figures 4 to 9 illustrate the terminals 34 which are inserted inside the input orifices 32a of the electronic control connector 30, objects of the present invention.

The electronic control connector 30 being used for electrically connecting an electronic control 50 to a hermetic compressor 200.

In a preferred embodiment, the electronic control 50 can be a frequency inverter provided with various electronic circuits having different functions, such as, for example, a power circuit with input stage for electromagnetic interference filtering and a rectifier bridge stage for converting an alternating current coming from an external power source into a continuous voltage, a control circuit (microcontroller or Digital Signal Processor - DSP), an auxiliary power source for generating all internal voltages for other circuits or components of the inverter, a circuit formed by power semiconductors for driving the electric motor employed in the compressor, among others.

Obviously, this is just a preferred embodiment, such that alternatively the electronic control 50 can be another type of component or a combination of other components, capable of controlling the hermetic compressor 200, such as the start-up system for compressor with single-phase motor, a thermostat system for controlling the temperature of a cooler, a motor control system with Taps for arrangement in 110V or 220V, among others.

The electronic control 50 is used for controlling the voltage and the frequency applied to the hermetic compressor 200, specifically for variable capacity compressors 200, thus varying the pumping speed of the cooling gas, that is, its mass flow, in accordance with the system requirement and its demand for cooling.

In a preferred embodiment, the hermetic compressor 200 is driven by three-phase brushless DC electric motors. However, it is important to note that the present invention is not limited to just this type of electric motor, such that other single-phase, two-phase or three-phase motors can be used, depending on the desired application.

The electronic control 50, object of the present invention, can be disposed on a first face 11 of a printed circuit board 10, on a second face 12 of the printed circuit board 10 or on both faces 11, 12. In a preferred embodiment, the first face 11 is the one that faces an outer casing 150 and the second face 12 is the one facing a support surface 201 of the hermetic compressor, as detailed ahead. The disposition on a certain face neither establishes a limitative character, nor alters the innovative characteristics of the present invention.

In general terms, the printed circuit board 10 is a board known in the state of the art, and can be made of phenolic, fiberglass, polyester fiber, diverse specific polymer-based films, among others. The first face 11 and a second face 12 of the printed circuit board 10 being provided with fine copper foils, which establish conduction tracks, where the components of the electronic control 50 are soldered and electrically interconnected to each other.

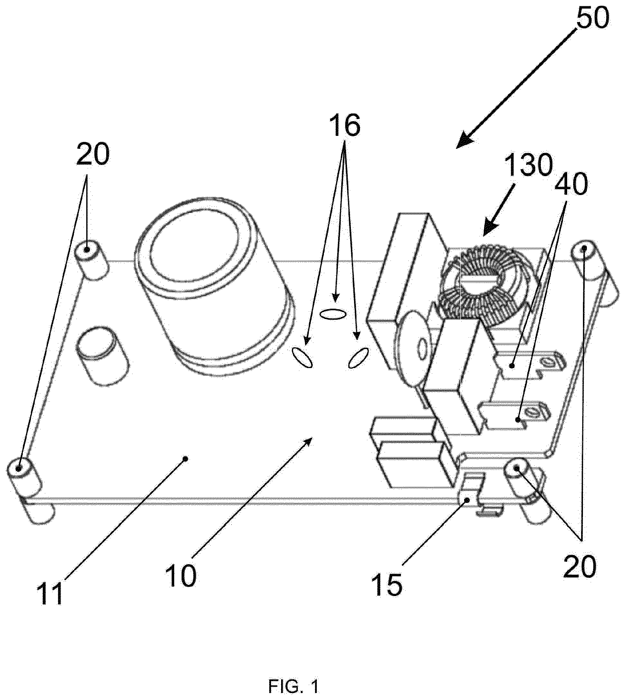

Further, still in reference to figure 1, it can be noted that it illustrates that the printed circuit board 10 is provided with external feed terminals 40 of the printed circuit board 10, the terminals 40 being electrically connected to the electronic control 50 and to an external voltage feed source (not shown).

It is also noted that the printed circuit board 10 is provided with at least a fixing orifice 16, which receives the electronic control connector 30, as described ahead.

Regarding figures 2 and 3, it can be noted that they illustrate the electronic control connector 30, object of the present invention. In a preferred embodiment, the electronic control connector 30 is made of insulating plastic materials resistant to the high electric currents to be applied to the hermetic compressor 200.

It is further noted from figures 2 and 3 that the electronic control connector 30 comprises at least an input orifice 32a, at least a first support wall 32b, at least a second support wall 32c and at least a fixing leg 33.

It is noted that the at least a first support wall 32b and the at least a second support wall 32c are adjacent to the input orifice 32a. More specifically, the at least a first and a second support walls 32b, 32c are opposite to each other in relation to the at least an input orifice 32a, such that they substantially form a cavity or a passage duct from the outside to the inside of the connector 30.

The at least a first support wall 32b being further provided with a recess 32d that surpasses the sides of the at least a first support wall 32b and being positioned in an intermediary region between the upper and lower ends of said first support wall 32b.

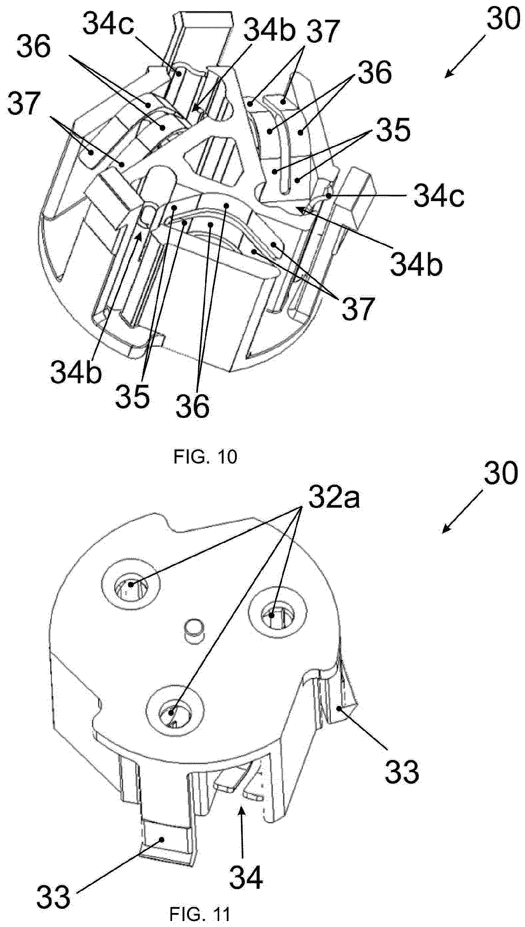

Said electronic control connector 30 receiving therein at least an input orifice 32a at least a terminal 34, as illustrated in figures 10 and 11 and as described in greater detail ahead.

In relation to the at least a terminal 34, illustrated in figures 4 to 9, it is noted that it is inside the at least an input orifice 32a, as described ahead and as illustrated in figures 10 and 11. In a preferred embodiment, the at least a terminal 34 is made of phosphor bronze, capable of conducting electricity and having considerable resistance to corrosion and is approximately 0.40 millimeter (mm) thick.

Other materials such as copper alloys, tin alloys, stainless steels, among others, could also be used. It must be emphasized that the material of the at least a terminal 34 should conduct electricity and should be resistant to corrosion and to the high electric currents to be applied to the hermetic compressor 200.

In further reference to figures 4 to 9, it is noted that the at least a terminal 34 comprises an upper portion 34a, a lower portion 34b, a side support projection 34c, an electric contact portion 34d and a fixing projection 34e.

The upper portion 34a is substantially X-shaped, formed by two elliptical portions, the first portion on the horizontal axis having a wider cross-section in length (6.00 millimeters (mm)) and shorter in width compared to the second portion on the vertical axis (2.00 millimeters (mm)). The second portion on the vertical axis presenting one of the ends with greater curvature than the other and having an inclination A of approximately 30° and 2.00 millimeters (mm) in length. The intersection of the portions defines a central orifice. It is noted that it extends from the upper portion 34a to the lower portion 34b of the terminal 34. Preferably, the central orifice is approximately 2.60 millimeters (mm) in diameter.

It must be emphasized that said shape and measurements refer solely to a preferred embodiment, such that any other shapes or measurements can be used, provided that the central orifice has a cooperating shape with the shape of the input orifice 32a of the electronic control connector 30.

Figures 4 to 9 also illustrate a side support projection 34c, which extends sidewardly along one of the ends of the horizontal portion of the upper portion 34a of the terminal 34. Said side support projection 34c extending linearly from the upper portion 34a to beyond the lower portion 34b, that is, the side support projection 34c has a greater length than the one comprised between the upper portion 34a and the lower portion 34b.

Preferably, the length between the upper portion 34a and the lower portion 34b is 6.50 millimeters (mm) and that of the side support projection 34c is 11.00 millimeters (mm). Moreover, the side support projection 34c in its greater length than the one comprised between the upper portion 34a and the lower portion 34b is 0.60 millimeter (mm) distant from the vertical axis of the central orifice.

It must be emphasized that although the terminal 34 presents a single side support projection 34c, said embodiment does not represent a limitative character. In other words, the terminal 34 could comprise a plurality of side support projections 34c or even a projection 34c extending along part of or all the outer surface of the horizontal and vertical portions of the upper and lower portions 34a, 34b. The embodiments in which the terminal 34 does not present a single side support projection 34c do not form part of the invention.

Another element illustrated in figures 4 to 9 is the electric contact portion 34d. It can be noted that it projects outwardly from the end and in an opposite direction to a vertical axis of the lower portion 34b.

In a preferred embodiment, the electric contact portion 34d comprises a curvilinear shape, a V-shape or a U-shape. It is noted that the shapes cited are not compulsory, such that any other shapes could be used, provided that their functionality is substantially similar to that of the preferred shapes.

Further preferably, the electric contact portion 34d is formed by a first straight portion 35, a curvilinear portion 36 and a second straight portion 37. The first straight portion 35 projecting from the end and in an opposite direction to the lower portion 34b, the curvilinear portion 36 starting from the end of the first straight portion 35 and a second straight portion 37 starting from the end of the curvilinear portion 36. The function of the second straight portion 37 is to guide the terminal 34 inside the connector 30, as seen in figure 10 and which will be described in greater detail ahead.

Preferably, the length of the first straight portion 35 is 1.40 millimeter (mm) and begins after a patch with curvature B of 140 degrees and a radius of 2.00 millimeters (mm), the curvilinear portion 36 has a curvature C of 90 degrees and radius of 2.50 millimeters (mm) and the second straight portion 37 has a length of 4.30 millimeters (mm). The thickness of the first straight portion 35, of the curvilinear portion 36 and of the second straight portion 37 being 0.40 millimeter (mm). The vertex of the curvilinear portion 36 being 1.00 millimeter (mm) higher and distant from the end of the side support projection 34c.

The length between the end of the second straight portion 37 to the end of the terminal 34 opposite the second straight portion 37 being approximately 12.56 millimeters (mm) and the length between the vertex of the curvilinear portion 36 to the end of the terminal 34 opposite the second straight portion 37 being approximately 7.40 millimeters (mm).

Also in an embodiment which is not part of the invention, the terminal 34 comprises two electric contact portions 34d separated between a distance of 0.80 millimeter (mm) and having a maximum length between sides of approximately 4.00 millimeters (mm).

It is also noted that figures 4 to 9 show the fixing projection 34e in the terminal 34. Preferably, it is disposed between the upper portion 34a and the lower portion 34b of the terminal 34. More specifically, the fixing projection 34e projects outwardly and in the opposite direction to a vertical axis of the central orifice of the terminal 34, the fixing projection 34e being disposed and extending from a point near the upper portion 34a to a point near the lower portion 34b. The fixing projection 34e on the terminal 34 has a height of approximately 2.90 millimeters (mm) in relation to the vertical axis of the central orifice of the terminal 34. The fixing projection 34e having a width of 1.50 millimeter (mm) and an angle of approximately 30 degrees in relation to the vertical axis of the central orifice of the terminal 34.

It is noted that the at least a fixing leg 33 is a projection positioned on an outer circumference of an upper surface of the electronic control 30, the at least a fixing leg 33 having an outward-sticking tooth in an opposite direction to a vertical axis of an upper surface of the electronic control 30, and may be L-shaped. The at least a fixing leg 33 being disposed perpendicularly to the at least a first support wall 32b and to the at least a second support wall 32c.

It must be emphasized that the shape of the fixing leg 33 should be cooperative with the shape of the fixing orifice 16, such that the fixing leg 33 can be inserted, encased and locked on the printed circuit board 10.

The at least a fixing leg 33 is also made from plastic materials and presents a certain elasticity, so it elastically deforms towards the input orifice 32a by applying pressure. Said characteristic enables the electronic control connector 30 to be inserted and encased in the fixing orifice 16 of the printed circuit board 10.

After having been inserted into the fixing orifice 16, the pressure on the fixing leg 33 should be interrupted, so that the fixing leg 33 elastically deforms to its initial position. This characteristic enables the electronic control connector 30 to be locked in the fixing orifice 16 of the printed circuit board 10.

It must be emphasized that the above form of fixing is merely a preferred embodiment, and that any other form of fixing can be used, such as, for example, soldering the electronic control connector 30 on the printed circuit board 10, by soldering the at least a fixing leg 33 to the at least a fixing orifice 16. It must be emphasized that the form of fixing must guarantee permanent or provisional locking of the electronic control connector 30 in the fixing orifice 16 of the printed circuit board 10.

As previously highlighted, the at least a terminal 34 is inserted inside the at least an input orifice 32a of the electronic control connector 30.

More specifically, and as noted from figures 10 and 11, the upper portion 34a and the lower portion 34b of the terminal 34 are inserted into the cavity formed between the first and the second support walls 32b, 32c and the input orifice 32a of the electronic control connector 30.

When inserting the at least a terminal 34 inside the at least an input orifice 32a:
- the fixing projection 34e projects inwardly of the recess 32d of the electronic control connector 30. The fixing projection 34e being configured to lock the terminal 34 to the electronic control connector 30;
- the side support projection 34c remains disposed adjacent to the fixing leg 33, more specifically adjacently to an inner surface of the cavity formed between the first and the second support walls 32b, 32c and the input orifice 32a of the electronic control connector 30; and
- the terminal 34 is guided by the walls 32b and 32c for insertion into the connector 30.

After said insertion, the pressure created by the interference between the at least a fixing leg 33 and the wall of the at least an orifice 16 of the printed circuit board 10, that is, when pressing the connector 30 on the printed circuit board 10, deformation of the fixing leg 33 occurs. The electronic control connector 30 being encased in the at least a fixing orifice 16 on any of the faces 11, 12 of the printed circuit board 10.

After having been inserted into the fixing orifice 16, the pressure on the at least a fixing leg 33 should be interrupted, so that the fixing leg 33 elastically deforms to its initial position. This characteristic enables the electronic control connector 30 to be locked on the fixing orifice 16 of the printed circuit board 10.

It is noted that besides the electronic control connector 30 being mechanically fixed to the printed circuit board 10, an electrical connection is also established between the at least a terminal 34 of the electronic control connector 30 and the tracks of the printed circuit board 10 of the electronic control 50.

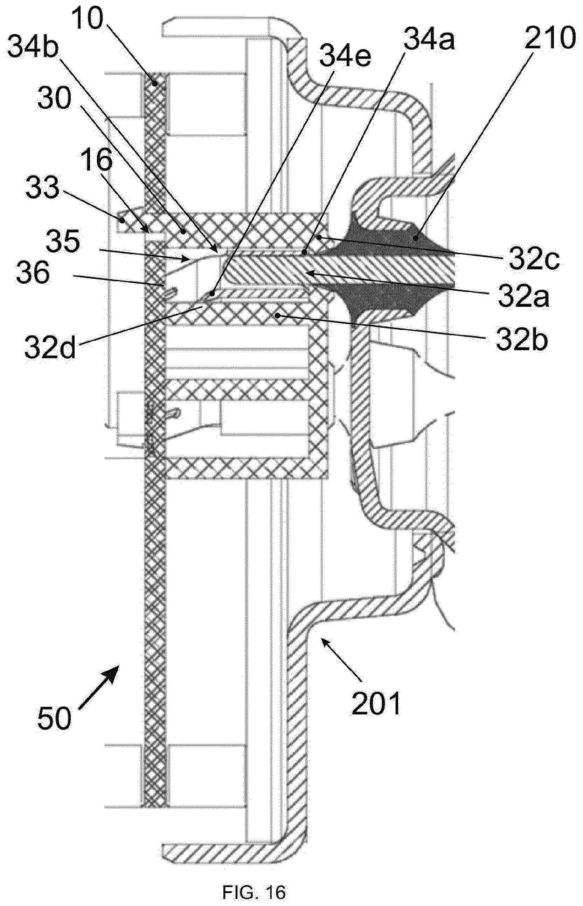

As well illustrated in figure 16, after having been fixed to the printed circuit board 10, some of the ends of the side support projection 34c of the terminal 34 establish a contact with the printed circuit board 10. The side support projection 34c prevents the terminal 34 from moving inside the electronic control connector 30, thus preventing excessive deformation of the electric contact portion 34d, when the electronic control connector 30 with the terminals 34 is connected to the connector of the hermetic compressor 210.

Similarly, the electric contact portion 34d presents a degree of freedom of movement capable of preventing the angular movement of the electric contact portion 34d, guaranteeing the electrical connection between the electric contact portion 34d and the tracks of the printed circuit board 10 of the electronic control 50.

The side support projection 34c acting as stopper, so that when connecting or removing the electronic control connector 30 of the connector of the hermetic compressor 210, the terminal 34 does not move, thus exercising an excessive force in the electric contact portion 34d. This excessive force may plastically deform the electric contact portion 34d meaning the electric contact between the electric contact portion 34d and the tracks of the printed circuit board 10 is lost.

After the mechanical and electrical fixing of the electronic control connector 30 to the printed circuit board 10, the electrical connection between said connector and the hermetic compressor 200 may be carried out.

In a preferred embodiment, the connector of the hermetic compressor 210 comprises at least three pins and the electronic control connector 30 comprises three terminals 34. It must be emphasized that the number of terminals 34 of the electronic control 30 and the number of pins of the connector of the hermetic compressor 210 are proportional and vary according to the hermetic compressor 200 used (single-phase, two-phase, three-phase).

When electrically connecting the hermetic compressor 200, the pins of the connector of the hermetic compressor 210 are inserted inside the cavity formed between the first and the second support walls 32b, 32c and the input orifice 32a of the electronic control connector 30, such that the terminal 34 of the electronic control connector 30 is electrically connected to the respective pin of the connector of the hermetic compressor 210.

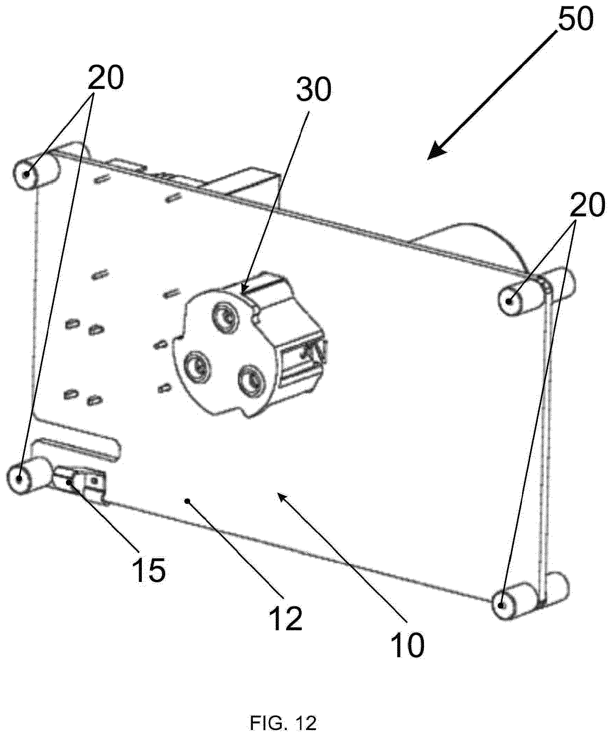

It is noted from figures 1 and 12 that at least a seating means 20 is fixed to the first face 11 and to the second face 12 of the printed circuit board 10. In a preferred embodiment, the at least a means 20 is disposed at the ends/vertices of the printed circuit board 10, symmetrically between both faces 11, 12. Symmetry occurs by means of the connection of the at least a seating means 20 between the faces 11, 12 by means of an orifice that surpasses the ends/vertices where it is disposed. This is merely a preferred embodiment, such that the at least a means 20 can be disposed on any region of the faces 11, 12 and can be maintained disconnected between them.

In a preferred embodiment, the at least a seating means 20 is made of elastically deformable materials, such as rubbers, polymers, springs or any other materials capable of elastically deforming by a mechanical effort (for example, compression).

It is also noted from figures 1 and 12 that the printed circuit board 10 is provided with an ground connection point 15. Preferably, this is a metal contact in the shape of a hook, for subsequent electrical connection to a support surface 201 of the hermetic compressor 200, as described ahead. The ground connection point 15 being electrically connected to the board 10 and being configured to earth an electromagnetic interference circuit 130 disposed on the printed circuit board 10.

Obviously, the hook shape is merely a preferred embodiment, and any other type of connection can be used, provided that it is capable of establishing contact with the support surface 201.

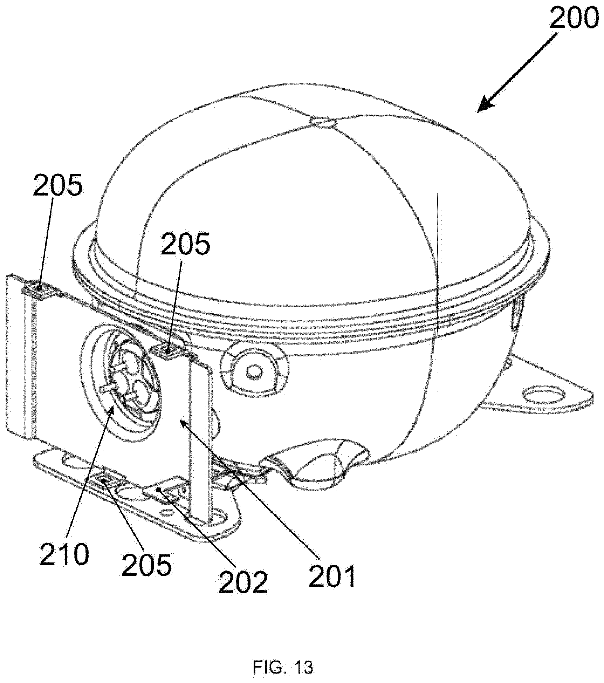

Regarding the hermetic compressor 200, it can be noted from figure 13 that it is provided with a support surface 201 and of a connector of the hermetic compressor 210. In a preferred embodiment, the support surface 201 has a shape cooperative with the shape of the printed circuit board 10, since latter will be fixed thereon. The support surface 201 presents in its central region an orifice for the passage of the connector of the hermetic compressor 210.

Preferably, the connector of the hermetic compressor 210 is provided with at least three connections (male connectors), which are electrically connected to the female-type connections of the electronic control connector 30 of the printed circuit board 10. The number of connections depends on the type of electric motor used (single-phase, two-phase or three-phase). As described ahead, said electrical connection enables the electric motor of the hermetic compressor 200 to receive power signals of the electronic control 50.

Additionally, figure 13 shows that the support surface 201 of the hermetic compressor 200 is provided with a projection 202 and of at least an encasement 205.

The projection 202 of the support surface 201 being configured for subsequent electrical connection with the ground connection point 15 of the printed circuit board 10, as described in greater detail ahead. The at least an encasement 205 being configured for receiving the outer casing 150 of the connection and fixing means. The hermetic compressor 200, the projection 202, the support surface 201 and the at least an encasement 205 being made of metal materials and all being grounded, to prevent damages from any electrical discharges and/or short circuits.

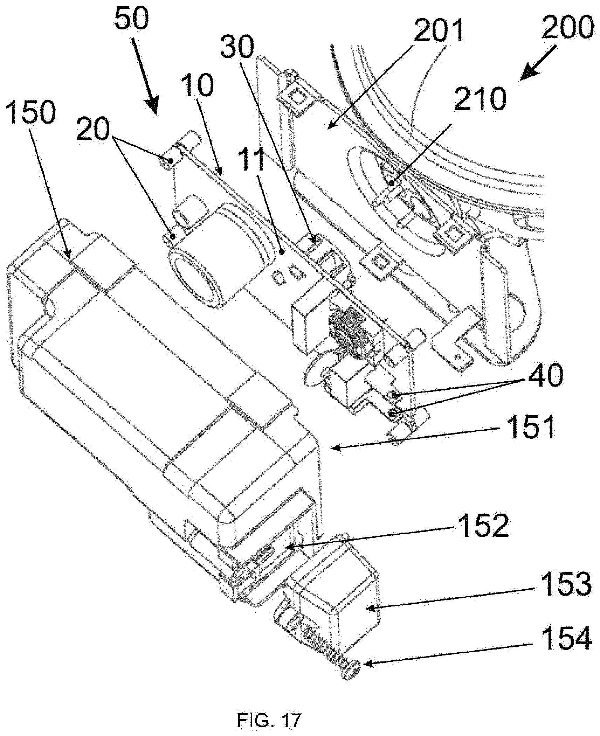

As can be noted from figure 17, the outer casing 150 of the connection means and fixing is provided with an internal cavity 151 and with an opening 152, preferably lateral, for access to the external power terminals 40 of the printed circuit board 10, as subsequently described. The outer casing 150 can be made of any material, especially plastic materials.

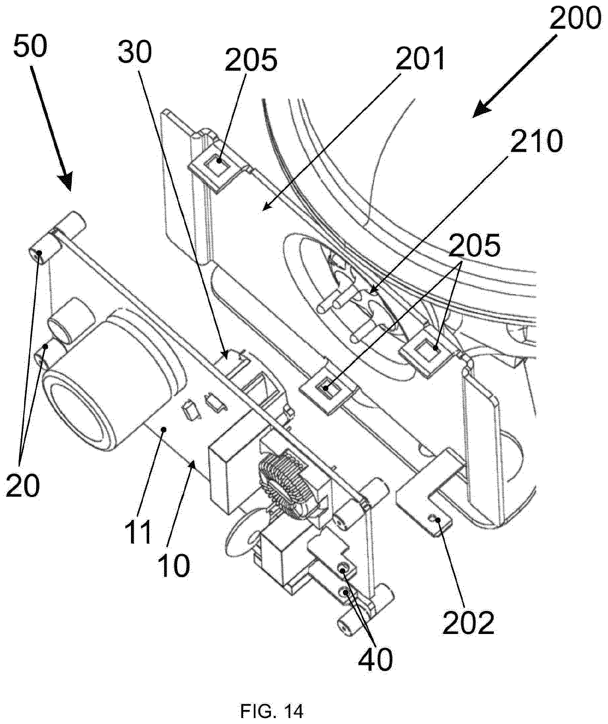

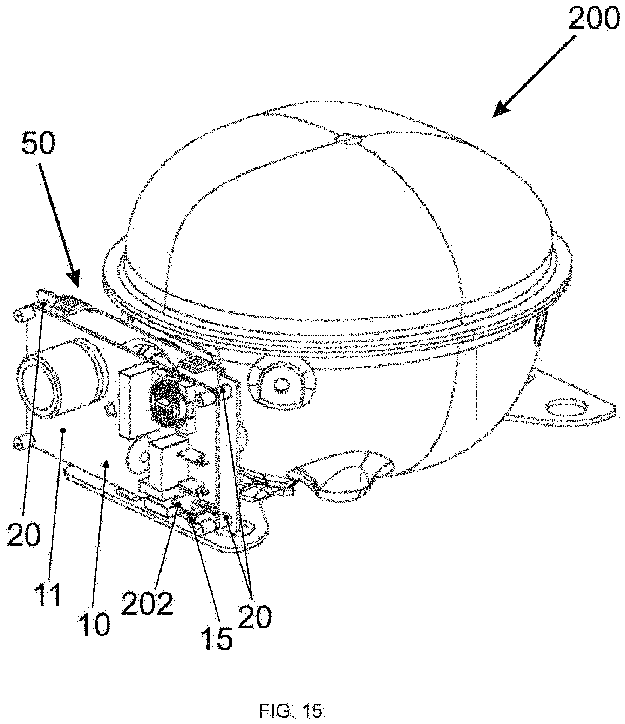

It can be seen from figures 13 to 15, the partial assembly of the connection and fixing means, object of the present invention, in the hermetic compressor 200, especially the electrical connection and fixing of the printed circuit board 10 with the electronic control 50 to the support surface 201 of the hermetic compressor 200.

The printed circuit board 10 with the electronic control 50 is initially placed parallel to the support surface 201 of the hermetic compressor 200 and being moved linearly until the electronic control connector 30 and the connector of the hermetic compressor 210 are aligned with each other.

It is noted that the printed circuit board 10 simultaneously:
- establishes a contact with the hermetic compressor 200, by means of a contact between the at least a seating means 20 disposed on the second face 12 and the support surface 201 of the hermetic compressor 200;
- establishes an electrical connection with the hermetic compressor 200, by means of an electrical connection between the electronic control connector 30 and the connector of the hermetic compressor 210; and
- establishes an electrical connection between the ground connection point 15 of the printed circuit board 10 and a projection 202 of the support surface 201 of the hermetic compressor 200.

It can be noted that after having established the electrical connection and the mechanical contacts between the above elements, the printed circuit board 10 is connected and fixed, respectively, to the connector of the hermetic compressor 210 and to the support surface 201, in a substantially stable manner and without the need to use fixing means (such as screws). Moreover, it is noted that the electromagnetic interference filtering circuit 130 of the board 10 is grounded, since an electrical ground connection was established with the hermetic compressor 200.

Figure 17 illustrates the complete assembly of the connection and fixing means, object of the present invention, with the hermetic compressor 200, especially the electrical connection and the fixing of the printed circuit board 10 with the electronic control 50 to the support surface 201 of the hermetic compressor, the encapsulation of the printed circuit board 10 with the electronic control 50 by the outer casing 150 and the fixing of the outer casing 150 to the support surface 201 of the hermetic compressor 200.

After said electrical connection and mechanical contacts previously described, the outer casing 150 receives and encapsulates, in its internal cavity 151, the printed circuit board 10 with the electronic control 50, with the at least a seating means 20 and with the electronic control connector 30.

After said encapsulation, the outer casing 150 establishes a contact with the at least a seating means 20 of the first face 11, the outer casing 150 being fixed to the support surface 201 of the hermetic compressor 200 by means of encasements 205 of the support surface 201. The external power terminals 40 of the printed circuit board 10 remain accessible from the side opening 152 of the outer casing 150. The side opening 152 being closed by a lid 153 and fixed by means of fixing elements 154 (such as screws).

As highlighted previously, the present invention brings various advantages over the state of the art, shorter time and fewer number of steps for assembly on the production lines, economy by eliminating cables, practicality in assembly, disassembly, maintenance, replacement of components, low production cost, among others.

Having described an example of a preferred embodiment, it should be understood that the scope of the present invention encompasses other possible variations, being limited solely by the content of the accompanying claims, potential equivalents included therein.

## Claims

1. An electronic control connector (30) to connect a pin of a connector of a hermetic compressor (210) to a track of a printed circuit board (10), the electronic control connector (30) comprising:
at least an input orifice (32a);
at least a fixing leg (33); and
at least a terminal (34) being inserted inside the at least an input orifice (32a) so as to establish an electrical connection between the at least a terminal (34) of the electronic control connector (30) and the tracks of the printed circuit board (10) of an electronic control (50), by means of an electronic contact portion (34d) of the terminal (34),
the electronic control connector (30) being adapted to be fixed to a printed circuit board (10) and electronic control (50) by means of a fixing between the fixing leg (33) and a fixing orifice (16) disposed on the printed circuit board (10) of the electronic control (50),
the terminal (34) comprising a side support projection (34c) disposed adjacent to the fixing leg (33), a first end of the side support projection (34c) being disposed adjacently to an inner surface of a cavity formed between first and second support walls (32b, 32c) and the input orifice (32a) of the electronic control connector (30), a second end of the side support projection (34c) being disposed adjacent to the printed circuit board (10), the side support projection (34c) being supported on the printed circuit board (10) so as to prevent deformation of the terminal (34) when being electrically connected to the pin of the connector of the hermetic compressor (210),
the electronic control connector (30) being configured to enable an angular movement of the electric contact portion (34d), guaranteeing the electrical connection between the electric contact portion (34d) and the tracks of the printed circuit board (10) of the electronic control (50), while the electronic control connector (30) is being fixed to the printed circuit board (10).

2. The electronic control connector (30), according to claim 1, **characterized in that** the electronic control connector (30) is fixed on the printed circuit board (10) by means of mechanical encasement between the at least a fixing leg (33) and the at least a fixing orifice (16).

3. The electronic control connector (30), according to claim 1, **characterized in that** the electronic control connector (30) is fixed on the printed circuit board (10) by soldering the at least a fixing leg (33) to the at least a fixing orifice (16).

4. The electronic control connector (30), according to claim 1, **characterized in that** the at least a fixing leg (33) is a projection positioned on an outer circumference of an upper surface of the electronic control connector (30), the at least a fixing leg (33) having an outward-sticking tooth in the opposite direction to a vertical axis of an upper surface of the electronic control connector (30), the at least a fixing leg (33) being L-shaped.

5. The electronic control connector (30), according to claim 4, **characterized in that** the at least a fixing leg (33) elastically deforms towards the input orifice (32a) by applying pressure, enabling the fixing of the electronic control connector (30) to the at least a fixing orifice (16) of the printed circuit board (10), the at least a fixing leg (33) elastically deforming to its initial position by interrupting the application of pressure, enabling the electronic control connector (30) to be locked in the at least a fixing orifice (16) of the printed circuit board (10).

6. The electronic control connector (30), according to claim 1, **characterized by** further comprising at least a first support wall (32b) and at least a second support wall (32c), both adjacent to the at least an input orifice (32a), the at least a first and the at least a second support wall (32b, 32c) being opposite to each other in relation to the at least input orifice (32a), the at least a first and the at least a second support wall (32b, 32c) and the at least an input orifice (32a) forming a cavity and the at least a first support wall (32b) being provided with a recess (32d).

7. The electronic control connector (30), according to claim 6, **characterized in that** the at least a terminal (34) comprises an upper portion (34a), a lower portion (34b), a side support projection (34c), an electric contact portion (34d) and a fixing projection (34e), the upper portion (34a) comprises a central orifice having a shape cooperative with the shape of an input orifice (32a) of the electronic control connector (30), the central orifice extending from the upper portion (34a) to the lower portion (34b) of the terminal (34), the side support projection (34c) extending linearly from the upper portion (34a) to beyond the lower portion (34b) along one of the sides of the terminal (34), the electric contact portion (34d) projecting outwardly from the end and in an opposite direction to a vertical axis of the lower portion (34b), the fixing projection (34e) is disposed between the upper portion (34a) and the lower portion (34b) of the terminal (34), the fixing projection (34e) projecting outwardly and in an opposite direction to a vertical axis of the central orifice of the terminal (34) from a point near the upper portion (34a) to a point near the lower portion (34b).

8. The electronic control connector (30), according to claim 7, **characterized in that** the electric contact portion (34d) comprises a first straight portion (35) which projects from the end and in an opposite direction to the lower portion (34b), a curvilinear portion (36) which begins from the end of the first straight portion (35) and a second straight portion (37) which begins from the end of the curvilinear portion (36).

9. The electronic control connector (30), according to claim 8, **characterized in that** the upper portion (34a) and the lower portion (34b) of the terminal (34) are inserted into the cavity formed between the first and the second support walls (32b, 32c) and the input orifice (32a) of the electronic control connector (30), the fixing projection (34e) is projected inwardly of the recess (32d) of the electronic control connector (30), the fixing projection (34e) being configured to lock the terminal (34) to the electronic control connector (30).

10. The electronic control connector (30), according to claim 1, **characterized in that** the side support projection (34c) is supported on the printed circuit board (10) and is configured to prevent the electric contact region (34d) from elastically deforming, the electric contact portion (34d) being provided with a degree of freedom of movement capable of enabling the angular movement of the electric contact portion (34d).

11. The electronic control connector (30), according to any one of the claims 1 to 10, **characterized in that** the electronic control connector (30) is electrically connectable to a connector of the hermetic compressor (210).

12. The electronic control connector (30), according to claim 11, **characterized in that** at least a pin of the connector of the hermetic compressor (210) is inserted into the cavity formed between the first and the second support walls (32b, 32c) and the input orifice (32a) of the electronic control connector (30), such that the terminal (34) of the electronic control connector (30) is electrically connected to the respective pin of the connector of the hermetic compressor (210), the number of terminals (34) of the electronic control (30) and the number of pins of the connector of the hermetic compressor (210) being proportional and vary in accordance with the hermetic compressor (200) used.

13. An electronic control (50) for driving a variable capacity hermetic compressor (200), comprising a printed circuit board (10) and an electronic control connector (30) as defined in any preceding claim.

## Patentansprüche

1. Verbinder (30) einer elektronischen Steuerung zum Verbinden eines Stifts eines Verbinders eines hermetischen Kompressors (210) mit einer Spur einer Platine (10), wobei der Verbinder (30) der elektronischen Steuerung umfasst:
mindestens eine Eingabeöffnung (32a);
mindestens ein Befestigungsbein (33); und
mindestens ein Terminal (34), das in die mindestens eine Eingabeöffnung (32a) eingesetzt wird, um mittels eines elektrischen Kontaktabschnitts (34d) des Terminals (34) eine elektrische Verbindung zwischen dem mindestens einen Terminal (34) des Verbinders (30) der elektronischen Steuerung und den Spuren der Platine (10) einer elektronischen Steuerung (50) herzustellen,
wobei der Verbinder (30) der elektronischen Steuerung angepasst ist, an einer Platine (10) und elektronischen Steuerung (50) mittels einer Befestigung zwischen dem Befestigungsbein (33) und einer Befestigungsöffnung (16) befestigt zu werden, die an der Platine (10) der elektronischen Steuerung angeordnet ist (50),
wobei das Terminal (34) einen Seitenträgervorsprung (34c) umfasst, der an das Befestigungsbein (33) angrenzend angeordnet ist,
wobei ein erstes Ende des Seitenträgervorsprungs (34c) an eine innere Fläche eines Hohlraums angrenzend angeordnet ist, der zwischen ersten und zweiten Trägerwänden (32b, 32c) und der Eingabeöffnung (32a) des Verbinders (30) der elektronischen Steuerung ausgebildet ist, ein zweites Ende des Seitenträgervorsprungs (34c) an die Platine (10) angrenzend angeordnet ist und der Seitenträgervorsprung (34c) auf der Platine (10) aufliegt, um eine Verformung des Terminals (34) zu vermeiden, wenn die elektrische Verbindung mit dem Stift des Verbinders des hermetischen Kompressors (210) hergestellt wird,
wobei der Verbinder (30) der elektronischen Steuerung konfiguriert ist, eine Winkelbewegung des elektrischen Kontaktabschnitts (34d) zu ermöglichen, um die elektrische Verbindung zwischen dem elektrischen Kontaktabschnitt (34d) und den Spuren der Platine (10) der elektronischen Steuerung (50) sicherzustellen, während der Verbinder (30) der elektronischen Steuerung an der Platine (10) befestigt wird.

2. Verbinder (30) einer elektronischen Steuerung nach Anspruch 1, **dadurch gekennzeichnet, dass** der Verbinder (30) der elektronischen Steuerung mittels mechanischem Einschluss zwischen dem mindestens einen Befestigungsbein (33) und der mindestens einen Befestigungsöffnung (16) an der Platine (10) befestigt ist.

3. Verbinder (30) einer elektronischen Steuerung nach Anspruch 1, **dadurch gekennzeichnet, dass** der Verbinder (30) der elektronischen Steuerung durch Schweißen des mindestens einen Befestigungsbeins (33) an die mindestens eine Befestigungsöffnung (16) an der Platine (10) befestigt ist.

4. Verbinder (30) einer elektronischen Steuerung nach Anspruch 1, **dadurch gekennzeichnet, dass** das mindestens eine Befestigungsbein (33) ein Vorsprung ist, der an einem Außenumfang einer oberen Fläche des Verbinders (30) der elektronischen Steuerung positioniert ist, das mindestens eine Befestigungsbein (33) einen nach außen weisenden Zahn in der gegenläufigen Richtung zu einer vertikalen Achse einer oberen Fläche des Verbinders (30) der elektronischen Steuerung aufweist, wobei das mindestens eine Befestigungsbein (33) L-förmig ist.

5. Verbinder (30) einer elektronischen Steuerung nach Anspruch 4, **dadurch gekennzeichnet, dass** sich das mindestens eine Befestigungsbein (33) in Richtung der Eingabeöffnung (32a) durch Aufbringen von Druck elastisch verformt, was die Befestigung des Verbinders (30) der elektronischen Steuerung an der mindestens einen Befestigungsöffnung (16) der Platine (10) erlaubt, wobei sich das mindestens eine Befestigungsbein (33) elastisch in seine Anfangsposition verformt, indem das Aufbringen von Druck unterbrochen wird, was es dem Verbinder (30) der elektronischen Steuerung ermöglicht, in der mindestens einen Befestigungsöffnung (16) der Platine (10) verriegelt zu werden.

6. Verbinder (30) einer elektronischen Steuerung nach Anspruch 1, gekennzeichnet, indem er ferner mindestens eine erste Trägerwand (32b) und mindestens eine zweite Trägerwand (32c) umfasst, die beide an die mindestens eine Eingabeöffnung (32a) angrenzen, wobei die mindestens eine erste und die mindestens eine zweite Trägerwand (32b, 32c) bezüglich der mindestens Eingabeöffnung (32a) einander gegenüberliegend befinden, wobei die mindestens eine erste und die mindestens eine zweite Trägerwand (32b, 32c) und die mindestens eine Eingabeöffnung (32a) einen Hohlraum ausbilden und die mindestens eine erste Trägerwand (32b) mit einem Ausschnitt versehen ist (32d).

7. Verbinder (30) einer elektronischen Steuerung nach Anspruch 6, **dadurch gekennzeichnet, dass** das mindestens eine Terminal (34) einen oberen Abschnitt (34a), einen unteren Abschnitt (34b), einen Seitenträgervorsprung (34c), einen elektrischen Kontaktabschnitt (34d) und einen Befestigungsvorsprung (34e) umfasst, wobei der obere Abschnitt (34a) eine zentrale Öffnung umfasst, die eine Form aufweist, die mit der Form einer Eingabeöffnung (32a) des Verbinders (30) der elektronischen Steuerung zusammenwirkt, wobei sich die zentrale Öffnung von dem oberen Abschnitt (34a) zu dem unteren Abschnitt (34b) des Terminals (34) erstreckt und sich der Seitenträgervorsprung (34c) linear von dem oberen Abschnitt (34a) über den unteren Abschnitt (34b) hinaus entlang einer der Seiten des Terminals (34) erstreckt und der elektrische Kontaktabschnitt (34d) von dem Ende aus und in gegenläufiger Richtung zu einer vertikalen Achse des unteren Abschnitts (34b) vorspringt, wobei der Befestigungsvorsprung (34e) zwischen dem oberen Abschnitt (34a) und dem unteren Abschnitt (34b) des Terminals (34) angeordnet ist, wobei der Befestigungsvorsprung (34e) auswärts und in gegenläufiger Richtung zu einer vertikalen Achse der zentralen Öffnung des Terminals (34) von einem Punkt in der Nähe des oberen Abschnitts (34a) aus zu einem Punkt in der Nähe des unteren Abschnitts (34b) vorspringt.

8. Verbinder (30) einer elektronischen Steuerung nach Anspruch 7, **dadurch gekennzeichnet, dass** der elektrische Kontaktabschnitt (34d) einen ersten geraden Abschnitt (35), der von dem Ende und in gegenläufiger Richtung zu dem unteren Abschnitt (34b) vorspringt, einen kurvenförmigen Abschnitt (36), der am Ende des ersten geraden Abschnitts (35) beginnt, und einen zweiten geraden Abschnitt (37), der am Ende des kurvenförmigen Abschnitts (36) beginnt, umfasst.

9. Verbinder (30) einer elektronischen Steuerung nach Anspruch 8, **dadurch gekennzeichnet, dass** der obere Abschnitt (34a) and der untere Abschnitt (34b) des Terminals (34) in den Hohlraum eingeführt werden, der zwischen den ersten und zweiten Trägerwänden (32b, 32c) und der Eingabeöffnung (32a) des Verbinders (30) der elektronischen Steuerung ausgebildet ist, wobei der Befestigungsvorsprung (34e) von der Aussparung (32d) des Verbinders (30) der elektronischen Steuerung aus einwärts vorspringt und der Befestigungsvorsprung (34e) konfiguriert ist, das Terminal (34) an dem Verbinder (30) der elektronischen Steuerung zu verriegeln.

10. Verbinder (30) einer elektronischen Steuerung nach Anspruch 1,
**dadurch gekennzeichnet, dass** der Seitenträgervorsprung (34c) auf der Platine (10) aufliegt und konfiguriert ist, zu verhindern, dass sich die elektrische Kontaktregion (34d) elastisch verformt, wobei der elektrische Kontaktabschnitt (34d) mit einem Grad von Bewegungsfreiheit ausgestattet ist, der in der Lage ist, die Winkelbewegung des elektrischen Kontaktabschnitts (34d) zu ermöglichen.

11. Verbinder (30) einer elektronischen Steuerung nach einem der Ansprüche 1 bis 10,
**dadurch gekennzeichnet, dass** der Verbinder (30) der elektronischen Steuerung elektrisch mit einem Verbinder des hermetischen Kompressors (210) verbunden werden kann.

12. Verbinder (30) einer elektronischen Steuerung nach Anspruch 11,
**dadurch gekennzeichnet, dass** mindestens ein Stift des Verbinders des hermetischen Kompressors (210) in den Hohlraum eingeführt wird, der zwischen den ersten und den zweiten Trägerwänden (32b, 32c) und der Eingabeöffnung (32a) des Verbinders (30) der elektronischen Steuerung ausgebildet ist, sodass das Terminal (34) des Verbinders (30) der elektronischen Steuerung elektrisch mit dem jeweiligen Stift des Verbinders des hermetischen Kompressors (210) verbunden ist, wobei die Anzahl der Terminals (34) der elektronischen Steuerung (30) und die Anzahl der Stifte des Verbinders des hermetischen Kompressors (210) proportional sind und dem verwendeten hermetischen Kompressor (200) entsprechend variieren.

13. Elektronische Steuerung (50) zur Ansteuerung eines hermetischen Kompressors (200) mit variabler Kapazität, umfassend eine Platine (10) und einen Verbinder (30) der elektronischen Steuerung wie einem der vorhergehenden Ansprüche definiert.

## Revendications

1. Connecteur de commande électronique (30) pour connecter une broche d'un connecteur d'un compresseur hermétique (210) à une piste d'une carte de circuit imprimé (10), le connecteur de commande électronique (30) comprenant :
au moins un orifice d'entrée (32a) ;
au moins une patte de fixation (33) ; et
au moins une borne (34) qui est insérée à l'intérieur de l'au moins un orifice d'entrée (32a) afin d'établir une connexion électrique entre l'au moins une borne (34) du connecteur de commande électronique (30) et les pistes de la carte de circuit imprimé (10) d'une commande électronique (50), au moyen d'une partie de contact électronique (34d) de la borne (34),
le connecteur de commande électronique (30) étant conçu pour être fixé à une carte de circuit imprimé (10) et à une commande électronique (50) au moyen d'une fixation entre la patte de fixation (33) et un orifice de fixation (16) disposé sur la carte de circuit imprimé (10) de la commande électronique (50),
la borne (34) comprenant une saillie de support latérale (34c) disposée de manière adjacente à la patte de fixation (33), une première extrémité de la saillie de support latérale (34c) étant disposée de manière adjacente à une surface interne d'une cavité formée entre des première et seconde parois de support (32b, 32c) et l'orifice d'entrée (32a) du connecteur de commande électronique (30), une seconde extrémité de la saillie de support latérale (34c) étant disposée de manière adjacente à la carte de circuit imprimé (10), la saillie de support latérale (34c) étant portée sur la carte de circuit imprimé (10) afin d'empêcher une déformation de la borne (34) lorsqu'elle est électriquement connectée à la broche du connecteur du compresseur hermétique (210),
le connecteur de commande électronique (30) étant configuré pour permettre un mouvement angulaire de la partie de contact électrique (34d), ce qui garantit la connexion électrique entre la partie de contact électrique (34d) et les pistes de la carte de circuit imprimé (10) de la commande électronique (50), tandis que le connecteur de commande électronique (30) est fixé sur la carte de circuit imprimé (10).

2. Connecteur de commande électronique (30) selon la revendication 1, **caractérisé en ce que** le connecteur de commande électronique (30) est fixé sur la carte de circuit imprimé (10) au moyen d'un encastrement mécanique entre l'au moins une patte de fixation (33) et l'au moins un orifice de fixation (16).

3. Connecteur de commande électronique (30) selon la revendication 1, **caractérisé en ce que** le connecteur de commande électronique (30) est fixé sur la carte de circuit imprimé (10) par soudage de l'au moins une patte de fixation (33) dans l'au moins un orifice de fixation (16).

4. Connecteur de commande électronique (30) selon la revendication 1, **caractérisé en ce que** l'au moins une patte de fixation (33) est une saillie positionnée sur une circonférence externe d'une surface supérieure du connecteur de commande électronique (30), l'au moins une patte de fixation (33) ayant une dent de blocage vers l'extérieur dans la direction opposée à un axe vertical d'une surface supérieure du connecteur de commande électronique (30), l'au moins une patte de fixation (33) étant en forme de L.

5. Connecteur de commande électronique (30) selon la revendication 4, **caractérisé en ce que** l'au moins une patte de fixation (33) se déforme élastiquement en direction de l'orifice d'entrée (32a) par l'application d'une pression, permettant la fixation du connecteur de commande électronique (30) dans l'au moins un orifice de fixation (16) de la carte de circuit imprimé (10), l'au moins une patte de fixation (33) se déformant élastiquement vers sa position initiale par l'interruption de l'application de pression, permettant au connecteur de commande électronique (30) d'être verrouillé dans l'au moins un orifice de fixation (16) de la carte de circuit imprimé (10).

6. Connecteur de commande électronique (30) selon la revendication 1, **caractérisé en ce qu'**il comprend en outre au moins une première paroi de support (32b) et au moins une seconde paroi de support (32c), toutes deux adjacentes à l'au moins un orifice d'entrée (32a), l'au moins une première et l'au moins une seconde paroi de support (32b, 32c) étant opposées l'une à l'autre par rapport à l'au moins un orifice d'entrée (32a), l'au moins une première et l'au moins une seconde paroi de support (32b, 32c) et l'au moins un orifice d'entrée (32a) formant une cavité et l'au moins une première paroi de support (32b) étant munie d'un évidement (32d).

7. Connecteur de commande électronique (30) selon la revendication 6, **caractérisé en ce que** l'au moins une borne (34) comprend une partie supérieure (34a), une partie inférieure (34b), une saillie de support latérale (34c), une partie de contact électrique (34d) et une saillie de fixation (34e), la partie supérieure (34a) comprend un orifice central ayant une forme qui coopère avec la forme d'un orifice d'entrée (32a) du connecteur de commande électronique (30), l'orifice central s'étendant de la partie supérieure (34a) à la partie inférieure (34b) de la borne (34), la saillie de support latérale (34c) s'étendant linéairement de la partie supérieure (34a) jusqu'au-delà de la partie inférieure (34b) le long de l'un des côtés de la borne (34), la partie de contact électrique (34d) faisant saillie vers l'extérieur à partir de l'extrémité et dans une direction opposée à un axe vertical de la partie inférieure (34b), la saillie de fixation (34e) est disposée entre la partie supérieure (34a) et la partie inférieure (34b) de la borne (34), la saillie de fixation (34e) faisant saillie vers l'extérieur et dans une direction opposée à un axe vertical de l'orifice central de la borne (34), d'un point à proximité de la partie supérieure (34a) à un point à proximité de la partie inférieure (34b).

8. Connecteur de commande électronique (30) selon la revendication 7, **caractérisé en ce que** la partie de contact électrique (34d) comprend une première partie droite (35) qui fait saillie à partir de l'extrémité et dans une direction opposée à la partie inférieure (34b), une partie curviligne (36) qui débute à partir de l'extrémité de la première partie droite (35) et une seconde partie droite (37) qui débute à partir de l'extrémité de la partie curviligne (36).

9. Connecteur de commande électronique (30) selon la revendication 8, **caractérisé en ce que** la partie supérieure (34a) et la partie inférieure (34b) de la borne (34) sont insérées dans la cavité formée entre les première et seconde parois de support (32b, 32c) et l'orifice d'entrée (32a) du connecteur de commande électronique (30), la saillie de fixation (34e) fait saillie vers l'intérieur de l'évidement (32d) du connecteur de commande électronique (30), la saillie de fixation (34e) étant configurée pour verrouiller la borne (34) sur le connecteur de commande électronique (30).

10. Connecteur de commande électronique (30) selon la revendication 1, **caractérisé en ce que** la saillie de support latérale (34c) est portée sur la carte de circuit imprimé (10) et est configurée pour empêcher la région de contact électrique (34d) de se déformer de manière élastique, la partie de contact électrique (34d) étant munie d'un degré de liberté de mouvement apte à permettre le mouvement angulaire de la partie de contact électrique (34d).

11. Connecteur de commande électronique (30) selon l'une quelconque des revendications 1 à 10, **caractérisé en ce que** le connecteur de commande électronique (30) est apte à être électriquement connecté à un connecteur du compresseur hermétique (210).

12. Connecteur de commande électronique (30) selon la revendication 11, **caractérisé en ce qu'**au moins une broche du connecteur du compresseur hermétique (210) est insérée dans la cavité formée entre les première et seconde parois de support (32b, 32c) et l'orifice d'entrée (32a) du connecteur de commande électronique (30), de sorte que la borne (34) du connecteur de commande électronique (30) est électriquement connectée à la broche respective du connecteur du compresseur hermétique (210), le nombre de bornes (34) de la commande électronique (30) et le nombre de broches du connecteur du compresseur hermétique (210) étant proportionnels et variant selon le compresseur hermétique (200) utilisé.

13. Commande électronique (50) pour piloter un compresseur hermétique à capacité variable (200), comprenant une carte de circuit imprimé (10) et un connecteur de commande électronique (30) selon l'une quelconque des revendications précédentes.
